# FASCICULE DE BREVET EUROPEEN

(11) **EP 1 445 618 B1**
(45) Date de publication et mention de la délivrance du brevet: **18.11.2009**
(21) Numéro de dépôt: 04300009.0
(22) Date de dépôt: 06.01.2004
(51) Int. Cl.: G01R 15/18

(54) **Dispositif pour la mesure d'un courant éléctrique**
Vorrichtung zur Messung des fliessenden elektrischen Stromes
Device for measuring the electrical current

(30) Priorité: 14.01.2003 FR 0300342
(43) Date de publication de la demande: 11.08.2004
(73) Titulaire: Actaris S.A.S., 92120 Montrouge (FR)
(72) Inventeur: Guillon, Jean-Louis, 86440 Migne Auxance (FR)
(74) Mandataire: Feray, Valérie

(56) Documents cités:
- EP-A- 0 675 368
- FR-A- 2 800 167
- FR-A- 2 803 914
- US-A- 4 492 919

## Description

La présente invention concerne un dispositif pour la mesure d'un courant électrique. Ce dispositif est particulièrement adapté aux compteurs d'électricité.

Plusieurs types de capteurs de courant peuvent être utilisés dans un compteur d'électricité et sont décrits dans le document FR2800167.

En particulier, on connaît les capteurs à effet Hall dans lesquels un élément Hall est soumis à un champ magnétique engendré par un courant dans un enroulement primaire. La tension de Hall mesurée aux bornes de l'élément Hall est proportionnelle au courant traversant cet enroulement primaire.

Un autre type de capteur connu utilise un transformateur à mutuelle inductance. Ce type de capteur comporte par exemple un conducteur primaire ayant une forme générale de boucle ouverte en U et un enroulement secondaire sensible à un champ magnétique et enroulé sur un bobinage disposé à l'intérieur du conducteur primaire. L'enroulement secondaire est soumis à un champ magnétique engendré par le passage d'un courant dans le conducteur primaire et le signal disponible aux bornes du secondaire du transformateur est l'image de la dérivée en fonction du temps du signal appliqué au primaire. Le conducteur primaire est un câble conducteur cylindrique plein parcouru par le courant à mesurer et dont les extrémités viennent se fixer dans des bornes de contact situées sur le compteur.

Cette dernière solution pose cependant certaines difficultés.

Ainsi, dans le cas d'un courant de mesure élevé, le damètre du câble primaire doit être relativement important induisant une augmentation de la section du câble. Cette section élevée entraîne une augmentation de la taille, notamment en largeur, et du coût global du capteur de courant.

De plus, les compteurs d'électricité étant de plus en plus petits, il est également nécessaire de rendre le plus compact possible les capteurs de courant.

En outre, il existe différents types de bornes de contact permettant de connecter le compteur avec les extrémités du conducteur primaire. Les formes différentes de ces bornes imposent de modifier la structure du câble primaire assez difficile à manipuler de par sa forme cylindrique pleine.

Le document EP 0 675 368 A décrit un circuit d'entrée d'un appareil de mesure.

La présente invention vise à fournir un dispositif pour la mesure d'un courant électrique de taille et coût réduits permettant une adaptation facile à tous les types de bornes utilisées dans les compteurs électriques sans induire de contraintes sur l'enroulement secondaire lors du serrage des extrémités du conducteur primaire dans ou sur les bornes.

La présente invention propose à cet effet un dispositif pour la mesure d'un courant électrique comportant :
- un conducteur primaire ayant une forme générale de U, ledit conducteur primaire comprenant une âme de forme sensiblement circulaire centrée sur un axe, dit axe central, et deux branches, dites première et deuxième branches,
- un enroulement secondaire sensible à un champ magnétique, ledit enroulement secondaire étant disposé entre lesdites première et deuxième branche dudit conducteur primaire,
caractérisé en ce que ledit conducteur primaire est un profilé plat plié en U, ladite première branche présentant une torsion d'un angle de 90° suivant un premier sens de torsion et ladite seconde branche présentant une torsion selon un angle de 90° suivant un second sens de torsion.

Grâce à l'invention, le conducteur primaire est réalisé à l'aide d'un profilé plat en matériau conducteur dont la section est choisie pour laisser passer le courant de mesure. Le fait d'utiliser un profilé plat plié en U au lieu d'un conducteur cylindrique plein permet de diminuer la largeur globale du dispositif et donc de rendre plus compact le dispostif de mesure.

De plus, cette compacité permet de limiter la quantité de matière utilisée pour réaliser le blindage entourant les parties primaire et secondaire du dispositif. Ce blindage réalisé dans un matériau tel que du mumétal est en effet particulièrement coûteux.

En outre, il est facile de manipuler les branches du profilé plat plié en U ainsi que les extrémités de ces branches afin de leurs faire prendre une forme adéquate pour rentrer en contact avec les différents types de bornes de compteurs.

Enfin, il est important d'avoir les deux branches des sorties du conducteur primaire symétriques par rapport à un plan de symétrie (l'une tordue à gauche et l'autre tordue à droite ou inversement). Les deux torsions en sens inverse permettent en effet de rapprocher localement les deux branches du conducteur primaire de façon à cerner au plus près l'enroulement secondaire. Le conducteur primaire sortant d'un outil de fabrication présente des défauts géométriques qui doivent se situer dans une tolérance géométrique. Le serrage des deux branches, soit sur des bornes, soit dans des bornes, entraîne que, en présence d'un défaut, la contrainte résultante reste dans le plan de symétrie et ne peut déplacer l'enroulement secondaire ou déformer le blindage. Il est très important de pouvoir conserver au montage puis dans le temps la position respective de chacun des constituants du dispositif sans qu'une contrainte sur le conducteur primaire ne vienne modifier cette position.

Avantageusement, lorsque les deux branches présentent une torsion et selon un premier mode de réalisation, l'extrémité de chacune desdites première et deuxième branches est plane.

Ainsi, en partant d'un profilé plat vertical, on obtient deux branches ayant des extrémités planes horizontalement. Ces extrémités planes horizontales sont particulièrement utiles pour pénétrer dans des bornes dites pliées qui sont des bornes de forme sensiblement parallélépipédique. Lorsque le conducteur primaire est un câble plein, il est nécessaire d'écraser l'extrémité du conducteur afin de l'insérer dans ce type de borne.

Ces extrémités planes horizontalement peuvent également être fixées par vissage sur la partie supérieure de certaines bornes.

Avantageusement, lorsque les deux branches présentent une torsion et selon un deuxième mode de réalisation, l'extrémité de chacune desdites première et deuxième branches a une forme semi-cylindrique.

Ainsi, ces extrémités de forme semi-cylindrique sont particulièrement utiles pour pénétrer dans des bornes présentant des ouvertures cylindriques pour effectuer le contact électrique.

Avantageusement, ledit enroulement secondaire est sensiblement centré sur ledit axe central.

Avantageusement, le dispositif comprend un blindage prévu pour l'isolation magnétique de l'ensemble formé par ledit conducteur primaire et ledit enroulement primaire.

Avantageusement, ledit blindage est une bande repliée de façon à former une bague de forme sensiblement parallélépipédique entourant ledit conducteur primaire et ledit enroulement secondaire.

De manière avantageuse, le dispositif comprend une bobine sur laquelle est enroulé ledit enroulement secondaire et ladite bobine d'enroulement secondaire comporte des moyens de contact électrique, lesdits moyens de contact électrique étant pliés de façon à établir un contact électrique entre ledit blindage et une seule extrémité dudit enroulement secondaire.

Lesdits moyens de contact électrique sont par exemple réalisés à l'aide d'une seule tige conductrice ayant une extrémité pliée pour venir en contact avec le blindage.

Avantageusement, le dispositif comporte des moyens d'isolation électrique dudit conducteur primaire et dudit enroulement secondaire, lesdits moyens d'isolation comportant un réceptacle situé à l'intérieur dudit conducteur primaire et centré sur ledit axe central pour recevoir ledit enroulement secondaire.

Ainsi, on a une bonne isolation électrique entre le conducteur primaire et l'enroulement secondaire tout en assurant le centrage de l'enroulement secondaire.

De façon avantageuse, le dispositif comprend un blindage prévu pour l'isolation magnétique de l'ensemble formé par ledit conducteur primaire et ledit enroulement secondaire et lesdits moyens d'isolation sont recouverts par ledit blindage et comportent des moyens pour maintenir fixement ledit blindage.

Ainsi, il n'est pas nécessaire d'isoler individuellement le conducteur principal, le blindage étant séparé dudit conducteur principal par lesdits moyens d'isolation. Ce type d'isolation individuelle du conducteur principal pose en effet certains problèmes dans la mesure où elle nécessite d'enlever l'isolation au niveau des extrémités du conducteur faisant contact avec les bornes du compteur ; grâce à l'invention, cette opération est supprimée.

D'autres caractéristiques et avantages de la présente invention apparaîtront dans la description suivante de modes de réalisation de l'invention, donnés à titre illustratif et nullement limitatif.

Dans les figures suivantes :
- La figure 1 représente une vue globale d'un dispositif selon l'invention,
- La figure 2 représente une vue éclatée d'un dispositif selon l'invention,
- La figure 3 représente un premier mode de réalisation d'un conducteur primaire utilisé dans un dispositif selon l'invention,
- La figure 4 représente un deuxième mode de réalisation d'un conducteur primaire utilisé dans un dispositif selon l'invention.

Dans toutes les figures, les éléments communs portent les mêmes numéros de référence.

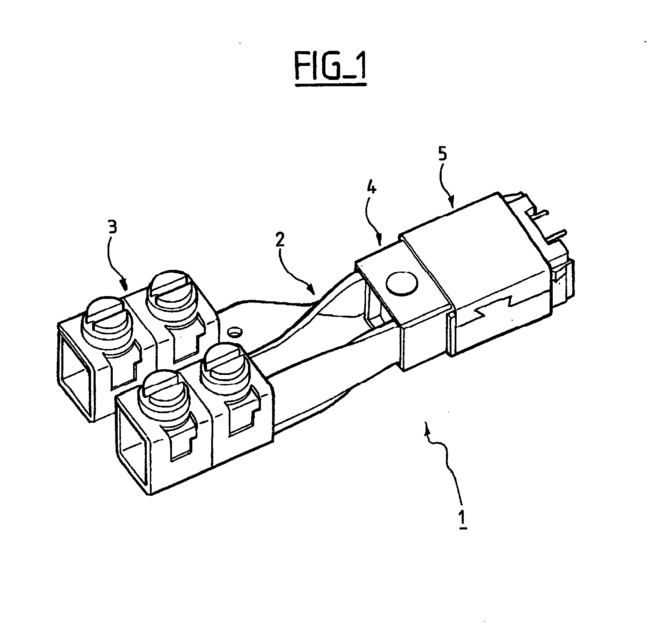

La figure 1 représente une vue globale d'un dispositif 1 pour la mesure d'un courant électrique selon l'invention.

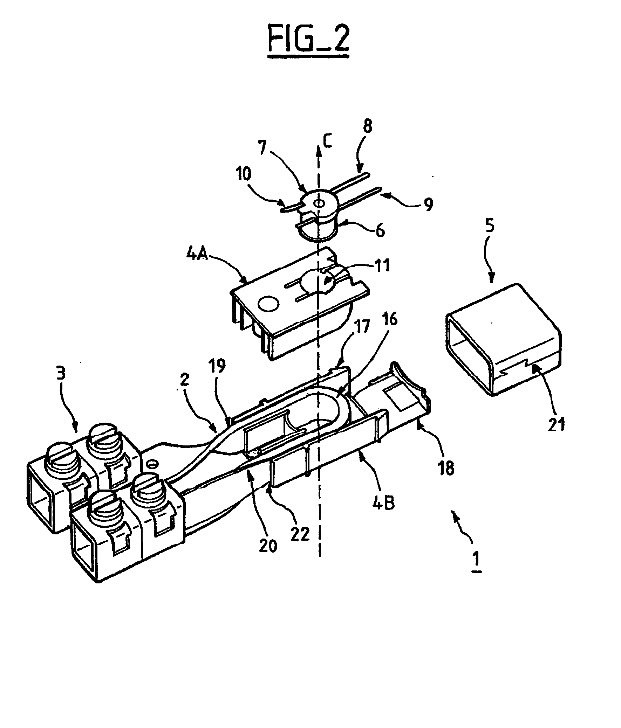

Le dispositif 1 sera décrit plus en détail en référence à la figure 2 qui représente une vue éclatée de ce même dispositif 1.

Le dispositif 1 comporte :
- un conducteur primaire 2,
- un enroulement secondaire 6,
- un blindage 5,
- des moyens d'isolation électrique 4.

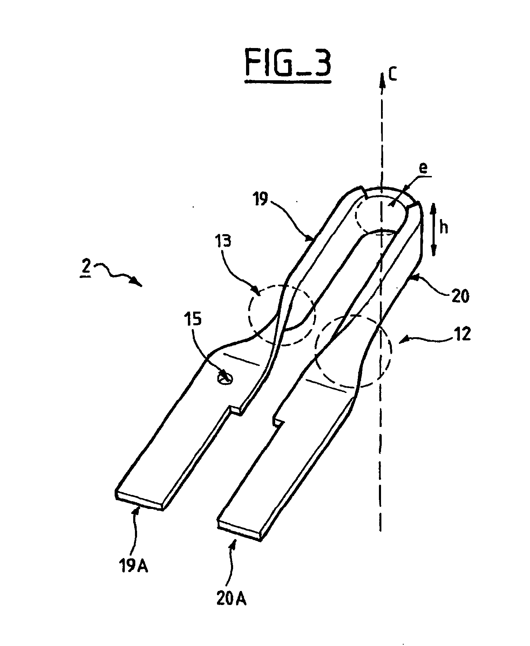

Le conducteur primaire 2 est un profilé plat plié en U tel que représenté en figure 3. Le profilé plat a par exemple une épaisseur e environ égale à 2 mm et une hauteur h environ égale à 10 mm pour un courant de mesure maximum de 120 A. Il est réalisé par exemple en cuivre électrolytique.

Le conducteur primaire 2 comporte :
- une première branche 19 ayant une extrémité 19A,
- une deuxième branche 20 ayant une extrémité 20A,
- une âme sensiblement circulaire 16 centrée sur un axe C, dit axe central.

La première branche 19 présente une torsion 13 de 90° dans le sens inverse du sens trigonométrique de sorte que son extrémité 19A soit plane horizontalement.

La deuxième branche 20 présente une torsion 12 de 90° dans le sens trigonométrique de sorte que son extrémité 20A soit plane horizontalement et que les deux branches 19 et 20 soit rapprochée localement au niveau des torsions 13 et 12.

Les extrémités planes horizontales 20A et 19A telles que représentées en figure 3 pénètrent en réalisant un contact électrique à plat dans des bornes 3 dites pliées qui sont des bornes de forme sensiblement parallélépipédique telles que représentées sur les figures 1 et 2. Ces bornes 3 appartiennent à un compteur d'électricité non représenté. Notons que les extrémités planes 20A et 19A comportent également chacune un trou 15 permettant de fixer ces extrémités par vissage sur des bornes adaptées.

En référence à la figure 2, l'enroulement secondaire 6 est un bobinage de fil, par exemple d'une épaisseur de 63 µm, bobiné sur une carcasse ou bobine 7 dont le diamètre est hors tout d'environ 8,4 mm et dont la hauteur est 9 mm. La carcasse 7 est traversée par deux tiges de contact électrique 8 et 9. L'extrémité 10 de la tige 8 est cambrée vers le haut de façon à réaliser un contact avec le blindage 5.

Les moyens d'isolation électrique 4 comportent deux coquilles 4A et 4B, respectivement supérieure et inférieure, en polypropylène. La coquille supérieure 4A comporte un réceptacle 11 situé à l'intérieur du conducteur primaire 2 et centré sur l'axe central C pour recevoir l'enroulement secondaire 6. La coquille inférieure 4B comporte des rainures 22 dans lesquelles viennent se loger les branches 19 et 20 du conducteur primaire 2.

Les deux coquilles 4A et 4B viennent épouser le conducteur primaire 2 afin de l'isoler électriquement du reste du dispositif 1; elles centrent et immobilisent l'enroulement secondaire 6 enroulé sur la carcasse 7 au centre de l'âme circulaire 16 du conducteur primaire 2.

Le blindage 5 est une bague de forme sensiblement parallélépipédique. Il est glissé sur les coquilles 4A et 4B et immobilise l'enroulement secondaire 6. Le blindage 5 est réalisé à l'aide une bande de Mumétal replié et agrafée par une queue d'aronde 21.

La coquille inférieure 4B comportent des harpons 17 permettant d'immobiliser le blindage 5 et un couvercle 18.

A l'introduction du blindage 5, ce dernier passe par-dessus les deux harpons 17 en déformant la coquille 4B ; une fois le blindage 5 en place, les deux harpons 17 reprennent leur position initiale et empêchent le blindage 5 de remonter. Afin d'immobiliser les deux harpons 17 et d'être sur que, malgré un choc, le blindage 5 restera en place, le couvercle 18 est refermé et empêche ainsi les harpons 17 de reculer.

La figure 3 représente un premier mode de réalisation d'un conducteur primaire utilisé dans un dispositif selon l'invention et a déjà été décrite en relation avec les figures 1 et 2.

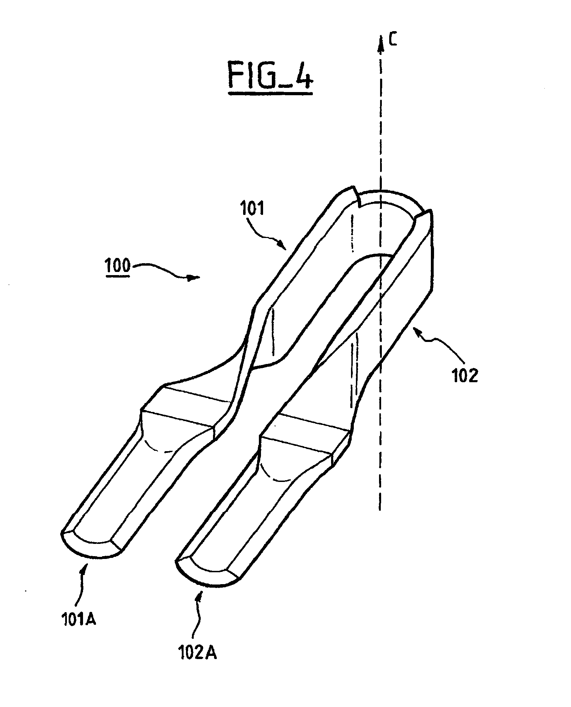

La figure 4 représente un deuxième mode de réalisation d'un conducteur primaire 100 utilisé dans un dispositif selon l'invention.

Le conducteur primaire 100 est identique au conducteur primaire tel que représenté en figure 3 à la différence que ses deux branches 101 et 102 présentent chacune une extrémité 101A et 102B ayant une forme semi-cylindrique.

Ces extrémités 101A et 102B de forme semi-cylindrique sont particulièrement utiles pour pénétrer dans des bornes présentant des ouvertures cylindriques afin de réaliser le contact électrique avec un compteur.

Bien entendu, l'invention n'est pas limitée aux modes de réalisations qui viennent d'être décrit.

Notamment, la forme des extrémités des branches du conducteur primaire a été décrite comme étant plane ou semi-cylindrique mais on peut également envisager d'autres formes permettant de s'adapter à d'autres types de bornes.

## Revendications

1. Dispositif (1) pour la mesure d'un courant électrique comportant :
- un conducteur primaire (2) ayant une forme générale de U, ledit conducteur primaire comprenant une âme (16) de forme sensiblement circulaire centrée sur un axe (C), dit axe central, et deux branches, dites première (19) et deuxième (20) branches,
- un enroulement secondaire (6) sensible à un champ magnétique, ledit enroulement secondaire étant disposé entre lesdites première (19) et deuxième (20) branche dudit conducteur primaire (2),
ledit conducteur primaire (2) est un profilé plat plié en U, ladite première branche (19) présentant une torsion (13) d'un angle de 90° suivant un premier sens de torsion et **caractérisé en ce que** ladite seconde branche (20) présentant une torsion (12) selon un angle de 90° suivant un second sens inverse de torsion.

2. Dispositif (1) selon la revendication précédente **caractérisé en ce que** l'extrémité (19A, 20A) de chacune desdites première et deuxième branches (19, 20) est plane.

3. Dispositif selon la revendication 1 **caractérisé en ce que** l'extrémité (101A, 102A) de chacune desdites première et deuxième branches (101,102) a une forme semi-cylindrique.

4. Dispositif (1) selon l'une des revendications précédentes **caractérisé en ce que** ledit enroulement secondaire (6) est sensiblement centré sur ledit axe central (C).

5. Dispositif (1) selon l'une des revendications précédentes **caractérisé en ce qu'**il comprend un blindage (5) prévu pour l'isolation magnétique de l'ensemble formé par ledit conducteur primaire (2) et ledit enroulement primaire (6).

6. Dispositif (1) selon la revendication 5 **caractérisé en ce que** ledit blindage (5) est une bande repliée de façon à former une bague de forme sensiblement parallélépipédique entourant ledit conducteur primaire et ledit enroulement secondaire.

7. Dispositif (1) selon l'une des revendications 5 ou 6 **caractérisé en ce qu'**il comprend une bobine (7) sur laquelle est enroulé ledit enroulement secondaire (6) et **en ce que** ladite bobine d'enroulement secondaire (6) comporte des moyens de contact électrique (10), lesdits moyens de contact électrique étant pliés de façon à établir un contact électrique entre ledit blindage (5) et une seule extrémité dudit enroulement secondaire (6).

8. Dispositif (1) selon l'une des revendications précédentes **caractérisé en ce qu'**il comporte des moyens d'isolation électrique (4) dudit conducteur primaire (2) et dudit enroulement secondaire (6), lesdits moyens d'isolation (4) comportant un réceptacle (11) situé à l'intérieur dudit conducteur primaire et centré sur ledit axe central (C) pour recevoir ledit enroulement secondaire (6).

9. Dispositif (1) selon la revendication précédente **caractérisé en ce que** qu'il comprend un blindage (5) prévu pour l'isolation magnétique de l'ensemble formé par ledit conducteur primaire et ledit enroulement secondaire et **en ce que** lesdits moyens d'isolation (4) sont recouverts par ledit blindage et comportent des moyens (17) pour maintenir fixement ledit blindage.

## Claims

1. A device (1) for measuring an electric current, comprising:
- a generally U-shaped primary conductor (2), said primary conductor comprising a substantially circular-shaped core (16) centered on an axis (C), the so-called center axis, and two branches, the so-called first (19) and second (20) branches,
- a secondary winding (6) responsive to a magnetic field, said secondary winding being arranged between said first (19) and second (20) branch of said primary conductor (2),
said primary conductor (2) being a flat U-bent profile, said first branch (19) having a torsion (13) of an angle of 90° along a first direction of torsion, and
**characterized in that**
said second branch (20) has a torsion (12) according to an angle of 90° along a second inverted direction of torsion.

2. The device (1) according to the preceding claim, **characterized in that** the end (19A, 20A) of each of said first and second branches (19, 20) is flat.

3. The device according to claim 1, **characterized in that** the end (101A, 102A) of each of said first and second branches (101, 102) has a half-cylindrical shape.

4. The device (1) according to any of the preceding claims, **characterized in that** said secondary winding (6) is substantially centered on said center axis (C).

5. The device (1) according to any of the preceding claims, **characterized in that** it comprises a shield (5) provided for magnetic insulation of the assembly formed by said primary conductor (2) and said secondary winding (6).

6. The device (1) according to claim 5, **characterized in that** said shield (5) is a strip folded back so as to form a substantially box-shaped bushing enclosing said primary conductor and said secondary winding.

7. The device (1) according to any of claims 5 or 6, **characterized in that** it comprises a coil (7), on which is wound said secondary winding (6), and **in that** said secondary coil winding (6) comprises electric contact means (10), with said electric contact means being folded so as to create electric contact between said shield (5) and one end of said secondary winding (6).

8. The device (1) according to any of the preceding claims, **characterized in that** it comprises means (4) for electrically insulating said primary conductor (2) and said secondary winding (6), with said insulating means (4) comprising a container (11) located within said primary conductor and centered on said center axis (C) to receive said secondary winding (6).

9. The device (1) according to the preceding claim, **characterized in that** it comprises a shield (5) provided for magnetic insulation of the assembly formed by said primary conductor and said secondary winding, and **in that** said insulating means (4) are covered by said shield and comprise means (17) for solidly holding said shield.

## Patentansprüche

1. Vorrichtung (1) zum Messen eines elektrischen Stroms, umfassend:
- einen im Allgemeinen U-förmigen Primärleiter (2), wobei der Primärleiter einen im Wesentlichen kreisförmigen Kern (16), der um eine Achse (C) zentriert ist, die Mittelachse genannt wird, und zwei Schenkel, die erste (19) und zweite (20) Schenkel genannt werden, umfasst,
- eine Sekundärwicklung (6), die auf ein Magnetfeld anspricht, wobei die Sekundärwicklung zwischen dem ersten (19) und zweiten (20) Schenkel des Primärleiters (2) angeordnet ist,
wobei der Primärleiter (2) ein flaches U-förmig gebogenes Profil ist, wobei der erste Schenkel (19) eine Verdrehung (13) in einem Winkel von 90° entlang einer ersten Verdrehungsrichtung aufweist, und
**dadurch gekennzeichnet, dass**
der zweite Schenkel (20) eine Verdrehung (12) gemäß einem Winkel von 90° entlang einer zweiten umgekehrten Verdrehungsrichtung aufweist.

2. Vorrichtung (1) nach dem vorhergehenden Anspruch, **dadurch gekennzeichnet, dass** das Ende (19A, 20A) jedes der ersten und zweiten Schenkel (19, 20) eben ist.

3. Vorrichtung nach Anspruch 1, **dadurch gekennzeichnet, dass** das Ende (101A, 102A) jedes der ersten und zweiten Schenkel (101, 102) eine halbzylindrische Form aufweist.

4. Vorrichtung (1) nach einem der vorhergehenden Ansprüche, **dadurch gekennzeichnet, dass** die Sekundärwicklung (6) im Wesentlichen um die Mittelachse (C) zentriert ist.

5. Vorrichtung (1) nach einem der vorhergehenden Ansprüche, **dadurch gekennzeichnet, dass** sie eine Abschirmung (5) umfasst, die für die magnetische Isolation der durch den Primärleiter (2) und die Sekundärwindung (6) gebildete Anordnung bereitgestellt wird.

6. Vorrichtung (1) nach Anspruch 5, **dadurch gekennzeichnet, dass** die Abschirmung (5) ein Band ist, das umgebogen wird, um eine im Wesentlichen quaderförmige Hülse zu bilden, die den Primärleiter und die Sekundärwicklung umgibt.

7. Vorrichtung (1) nach einem der Ansprüche 5 oder 6, **dadurch gekennzeichnet, dass** sie eine Spule (7) umfasst, auf der die Sekundärwicklung (6) aufgewickelt ist, und dass die sekundäre Wicklungsspule (6) elektrische Kontaktmittel (10) umfasst, wobei die elektrischen Kontaktmittel gebogen sind, um einen elektrischen Kontakt zwischen der Abschirmung (5) und einem einzigen Ende der Sekundärwicklung (6) herzustellen.

8. Vorrichtung (1) nach einem der vorhergehenden Ansprüche, **dadurch gekennzeichnet, dass** sie Mittel (4) zum elektrischen Isolieren des Primärleiters (2) und der Sekundärwicklung (6) umfasst, wobei die Isoliermittel (4) ein Behältnis (11) umfassen, das sich im Innern des Primärleiters befindet und um die Mittelachse (C) zentriert ist, um die Sekundärwicklung (6) aufzunehmen.

9. Vorrichtung (1) nach dem vorhergehenden Anspruch, **dadurch gekennzeichnet, dass** sie eine Abschirmung (5) umfasst, die für die magnetische Isolation der durch den Primärleiter und die Sekundärwindung gebildete Anordnung bereitgestellt wird, und dass die Isoliermittel (4) mit der Abschirmung abgedeckt sind und Mittel (17) umfassen, um die Abschirmung ortsfest zu halten.
